(19)

Europäisches Patentamt

European Patent Office

Office européen des brevets

(11) **EP 4 123 344 A1**

(12) **EUROPEAN PATENT APPLICATION**
published in accordance with Art. 153(4) EPC

(43) Date of publication:
**25.01.2023 Bulletin 2023/04**

(21) Application number: **21771001.1**

(22) Date of filing: **17.03.2021**

(51) International Patent Classification (IPC):
*G02B 1/111* (2015.01)     *B32B 7/023* (2019.01)
*B32B 9/00* (2006.01)       *B32B 9/04* (2006.01)
*B32B 27/06* (2006.01)      *B32B 27/18* (2006.01)
*G02B 1/14* (2015.01)       *G02B 5/22* (2006.01)
*G02B 5/26* (2006.01)       *G02B 5/30* (2006.01)
*G02F 1/1335* (2006.01)     *G09F 9/00* (2006.01)
*H01L 27/32* (2006.01)      *H01L 51/50* (2006.01)
*H05B 33/02* (2006.01)

(52) Cooperative Patent Classification (CPC):
**B32B 7/023; B32B 9/00; B32B 9/04; B32B 27/06; B32B 27/18; G02B 1/111; G02B 1/14; G02B 5/22; G02B 5/26; G02B 5/30; G02F 1/1335; G09F 9/00; H01L 27/32; H01L 51/50; H05B 33/02**

(86) International application number:
**PCT/JP2021/010718**

(87) International publication number:
**WO 2021/187505 (23.09.2021 Gazette 2021/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.03.2020   JP 2020046690**

(71) Applicant: Dai Nippon Printing Co., Ltd.
**Tokyo 162-8001 (JP)**

(72) Inventors:
• **NOMURA, Takahisa**
  **Tokyo 162-8001 (JP)**
• **HORII, Atsushi**
  **Tokyo 162-8001 (JP)**
• **SAKAI, Toshiyuki**
  **Tokyo 162-8001 (JP)**
• **ISOJIMA, Seiichi**
  **Tokyo 162-8001 (JP)**

(74) Representative: **Cabinet Beau de Loménie**
  **158, rue de l'Université**
  **75340 Paris Cedex 07 (FR)**

(54) **OPTICAL LAMINATE, POLARIZING PLATE USING SAME, SURFACE PLATE, AND IMAGE DISPLAY DEVICE**

(57)     Provided is an optical laminate capable of suppressing deterioration of visibility in a high-temperature environment. The optical laminate comprises a layer comprising a metal oxide on a plastic film, wherein the emissivity of the optical laminate for light with a wavelength range of 2000 nm or more and 22000 nm or less is 0.27 or more and 0.75 or less as measured from the side of the layer comprising a metal oxide with respect to the plastic film.

EP 4 123 344 A1

**Description**

Technical Field

The present disclosure relates to an optical laminate, and a polarizing plate, a surface plate and an image display device each using the optical laminate.

Background Art

In recent years, image display devices such as liquid crystal display devices and organic EL display devices have found their way into a wider range of applications, and used for smartphones, car navigation systems, televisions, monitors, digital cameras, and the like.

Among image display devices, car navigation systems are often installed in the dashboards of automobiles. Portable image display devices such as smartphones are also often carried in automobiles.

In the middle of summer, the interior of an automobile is subjected to high temperature, and in particular, the temperature of a dashboard may reach nearly 80°C. Thus, an image display device may be exposed to high temperature in the automobile for a long time, and in such a case, there is a risk of deterioration of various kinds of performance of the image display device.

As means for suppressing a rise in temperature of the interior of an automobile, laminated glass having a heat wire shielding structure has been proposed (e.g. Patent Literature 1).

Citation List

Patent Literature

PTL 1: WO 2019/167897

Summary of Invention

Technical Problem

When the laminated glass of Patent Literature 1 is used as window glass of an automobile, a rise in temperature of the interior of the automobile can be suppressed to a certain degree. However, in an automobile with no measures taken for suppressing a rise in temperature, an image display device is exposed to high temperature.

For this reason, laminated glass as in Patent Literature 1 may be used as protection glass for an image display device.

However, when an image display device for which laminated glass as in Patent Literature 1 is used as protection glass is exposed to a high-temperature environment, a problem of deterioration of visibility of the image display device frequently occurs. When laminated glass as in Patent Literature 1 is used as protection glass for an image display device, there is also a problem of increase in the thickness.

The present disclosure has been made in view of these circumstances, and an object of the present disclosure is to provide an optical laminate capable of suppressing deterioration of visibility in a high-temperature environment, and a polarizing plate, a surface plate and an image display device each using the optical laminate.

Solution to Problem

The present disclosure provides the following [1] to [4].

[1] An optical laminate, comprising a layer comprising a metal oxide on a plastic film, wherein an emissivity of the optical laminate for light with a wavelength range of 2000 nm or more and 22000 nm or less is 0.27 or more and 0.75 or less as measured from a side of the layer comprising a metal oxide with respect to the plastic film.

[2] A polarizing plate comprising: a polarizer; a first transparent protection plate disposed on one side of the polarizer; and a second transparent protection plate disposed on the other side of the polarizer, wherein at least one selected from the group consisting of the first transparent protection plate and the second transparent protection plate is the optical laminate according to [1].

[3] A surface plate for an image display device, comprising the optical laminate according to [1] bonded onto a resin plate or a glass plate.

[4] An image display device comprising the optical laminate according to [1] on a light emission surface of a display element.

Advantageous Effects of Invention

According to the present disclosure, it is possible to provide an optical laminate capable of suppressing deterioration of visibility in a high-temperature environment, and a polarizing plate, a surface plate and an image display device each using the optical laminate.

Brief Description of Drawing

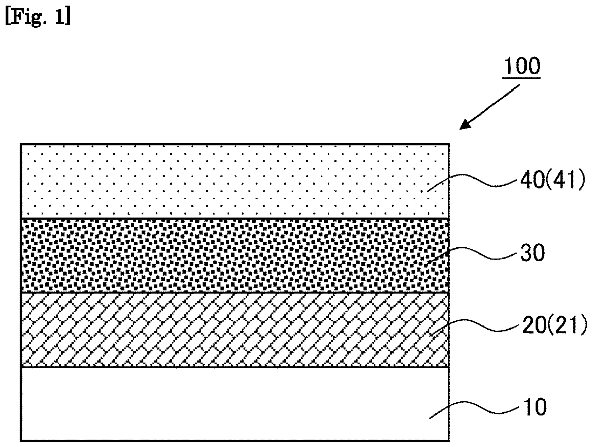

[Fig. 1] Fig. 1 is a schematic sectional view showing an embodiment of an optical laminate of the present disclosure.

Description of Embodiments

Hereinafter, embodiments of an optical laminate of the present disclosure, and a polarizing plate, a surface plate and an image display device each using the optical laminate will be described.

[Optical Laminate]

The optical laminate of the present disclosure comprises a layer comprising a metal oxide on a plastic film, wherein the emissivity of the optical laminate for light with a wavelength range of 2000 nm or more and 22000 nm or less is 0.27 or more and 0.75 or less as measured from the side of the layer comprising a metal oxide with respect to the plastic film.

In the present specification, the emissivity of the optical laminate for light with a wavelength range of 2000 nm or more and 22000 nm or less as measured from the side of the layer comprising a metal oxide with respect to the plastic film is sometimes referred to as "emissivity $\alpha$".

The emissivity means a relative value of the energy of light emitted by an object through heat emission against the energy of light emitted by a blackbody at the same temperature, which is defined as 1.

Fig. 1 is a schematic sectional view showing an embodiment of the optical laminate of the present disclosure.

An optical laminate 100 of Fig. 1 comprises a layer 30 comprising a metal oxide on a plastic film 10. The optical laminate 100 of Fig. 1 comprises a functional layer $\alpha$ (20) between the plastic film 10 and the layer 30 comprising a metal oxide. The functional layer $\alpha$ (20) of Fig. 1 is a single-layered hardcoat layer 21. The optical laminate 100 of Fig. 1 comprises a functional layer $\beta$ (40) on a side opposite to the plastic film 10 with respect to the layer 30 comprising a metal oxide. The functional layer $\beta$ (40) of Fig. 1 is a single-layered low refractive index layer 41.

<Plastic Film>

The plastic film is a support for a layer comprising a metal oxide and a functional layer as described later.

Supports other than the plastic film include glass. Glass is itself excellent in heat resistance, but is likely to retain heat because it has a large thickness. The thickness of glass is typically 0.5 mm or more. Thus, when glass is used as a support, there is a problem that the optical laminate is likely to be subjected to high temperature in a high-temperature environment, and layers forming the optical laminate, such as a layer comprising a metal oxide and a functional layer, or constituent members of an image display device, such as a display element are affected by the high temperature, so that visibility is likely to be deteriorated.

Examples of the plastic film include those formed from one or more selected from the group consisting of polyester, triacetyl cellulose (TAC), cellulose diacetate, cellulose acetate butylate, polyamide, polyimide, polyether sulfone, polysulfone, polypropylene, polymethylpentene, polyvinyl chloride, polyvinyl acetal, polyether ketone, polymethyl methacrylate, polycarbonate, polyurethane, amorphous olefin (cyclo-olefin-polymer: COP) and the like. The plastic film may be one obtained by co-extruding two or more resins, or one obtained by laminating two or more plastic films.

Among these plastic films, stretched films, particularly biaxially stretched films, of polyesters such as polyethylene terephthalate and polyethylene naphthalate are preferable in that they are excellent in mechanical strength and dimensional stability. Polyimide is preferable in that it has good flex resistance, and is easily applied to a foldable image display device and a rollable image display device. Plastic films obtained by co-extruding polycarbonate and polymethyl methacrylate are preferable in that they have good moldability.

As a substrate of the optical laminate, a thin glass film having a thickness of 5 $\mu$m or more and 200 $\mu$m or less can be used instead of a plastic film. In recent years, thin glass films have attracted attention as, for example, thin glass films for foldable image display. When a thin glass film is used, the smoothness of the optical laminate is improved, so that it can be expected that the emissivity decreases and penetration of heat is suppressed, and further, improvement of optical properties can be expected.

Among the plastic films, plastic films having a retardation value of 3000 nm or more and 30000 nm or less or plastic films having a 1/4 wavelength phase difference are suitable in that it is possible to prevent observation of unevenness with different colors on a display screen when an image is observed through polarized sunglasses.

The plastic film may be one subjected to known easy-adhesion treatment such as corona discharge treatment, primer treatment or surface preparation.

For handleability and suppression of deformation by heat, the thickness of the plastic film is preferably 5 $\mu$m or more, more preferably 10 $\mu$m or more, further preferably 25 $\mu$m or more.

On the other hand, if the thickness of the plastic film is excessively large, the plastic film may retain heat, leading to exertion of a harmful effect on visibility. If the plastic film retains heat, deterioration of visibility may persist for a long time because the temperature is unlikely to be lowered even by moving the optical laminate from a high-temperature environment to a normal-temperature environment. Thus, the thickness of the plastic film is preferably 350 $\mu$m or less, more preferably 150 $\mu$m or less, further preferably 90 $\mu$m or less, still further preferably 70 $\mu$m or less.

The thickness of the plastic film is preferably in the range of 5 $\mu$m or more and 350 $\mu$m or less, 5 $\mu$m or more and 150 $\mu$m or less, 5 $\mu$m or more and 90 $\mu$m or less, 5 $\mu$m or more and 70 $\mu$m or less, 10 $\mu$m or more and 350 $\mu$m or less, 10 $\mu$m or more and 150 $\mu$m or less, 10 $\mu$m or more and 90 $\mu$m or less, 10 $\mu$m or more and 70 $\mu$m or less, 25 $\mu$m or more and 350 $\mu$m or less, 25 $\mu$m or more and 150 $\mu$m or less, 25 $\mu$m or more and 90 $\mu$m or less, or 25 $\mu$m or more and 70 $\mu$m or less.

The thickness of each of layers forming the optical laminate, such as the plastic film, the layer comprising a metal oxide and the functional layer can be calculated from an average value at randomly selected 20 points on a picture of a cross-section of the optical laminate under scanning electron microscope (SEM) or a scanning transmission electron microscope (STEM). It is to be noted that the 20 portions are selected without focusing on certain locations.

The accelerating voltage and the magnification in STEM may be set depending on a layer to be measured.

<Layer Comprising Metal Oxide>

The layer comprising a metal oxide is a layer which plays a key role for setting the emissivity $\alpha$ of the optical laminate within a range described later.

Examples of the metal oxide include indium tin oxide (ITO); antimony oxide such as antimony trioxide, antimony doped tin oxide (ATO) and antimony pentaoxide; tin oxide; zinc oxide such as aluminum doped zinc oxide and gallium doped zinc oxide; and titanium oxide, and the layer preferably comprises one or more selected from the group consisting of these metal oxides.

Among the above-described metal oxides, ITO is preferable in that the emissivity $\alpha$ of the optical laminate is easily set within the range described later. In addition, ITO is preferable in that the refractive index of the layer comprising a metal oxide can be increased, and therefore the reflectance of the optical laminate in a visible light region is easily reduced by combination with an optionally formed low refractive index layer. In addition, ITO is preferable in that it has good transparency and high conductivity, so that it is easy for the optical laminate to have a good antistatic property.

For heat dissipation materials such as metal nitrides such as aluminum nitride and boron nitride which are commonly used as heat dissipation materials for heatsinks, it is difficult to set the emissivity to 0.75 or less.

For metals such as Au, Ag, Cu and Al which are exemplified in Patent Literature 1, it is difficult to set the emissivity to 0.27 or more, so that transparency may be deteriorated. The metals have a low refractive index, so that it is difficult to set the refractive index of the layer comprising a metal oxide within a range described later. The mirror reflection of the metals is so strong that backgrounds are reflected, resulting in deterioration of visibility. A deposited film of Ag has a migration problem.

Examples of embodiments comprising the layer comprising a metal oxide include the following (1) and (2):

(1) a layer comprising metal oxide particles and a binder resin; and
(2) a metal oxide film obtained by depositing a metal oxide by a physical vapor deposition method such as sputtering or a chemical vapor deposition method.

The above (1) is preferable in that it has better flex resistance over the above (2), and is easily applied to a foldable image display device and a rollable image display device.

«(1) Layer Comprising Metal Oxide Particles and Binder Resin» -Metal oxide particles-

Examples of the metal oxide particles include indium tin oxide (ITO) particles; antimony oxide particles such as particles of antimony trioxide, antimony doped tin oxide (ATO) and antimony pentaoxide; tin oxide particles; zinc oxide particles such as particles of aluminum doped zinc oxide and gallium doped zinc oxide; and titanium oxide particles, and the layer preferably comprises one or more types of particles selected from the group consisting of these types of metal oxide particles, and more preferably comprises ITO particles.

The average particle size of the metal oxide particles is preferably 2 nm or more and 200 nm or less, more preferably 7 nm or more and 100 nm or less, further preferably 8 nm or more and 80 nm or less, still further preferably 10 nm or more and 50 nm or less.

The average particle size of the metal oxide particles is preferably in the range of 2 nm or more and 200 nm or less, 2 nm or more and 100 nm or less, 2 nm or more and 80 nm or less, 2 nm or more and 50 nm or less, 7 nm or more and 200 nm or less, 7 nm or more and 100 nm or less, 7 nm or more and 80 nm or less, 7 nm or more and 50 nm or less, 8 nm or more and 200 nm or less, 8 nm or more and 100 nm or less, 8 nm or more and 80 nm or less, 8 nm or more and 50 nm or less, 10 nm or more and 200 nm or less, 10 nm or more and 100 nm or less, 10 nm or more and 80 nm or less, 10 nm or more and 50 nm or less.

In the present specification, the average particle size of each type of particles can be calculated by the following operations (1) to (3):

(1) a cross-section of the optical laminate is imaged by STEM, where the accelerating voltage is preferably 10 kV or more and 30 kV or less and the magnification is preferably 50000 times or more and 300000 times or less.
(2) 10 particles are randomly extracted on an observation image, and the particle sizes of the individual particles are then calculated, where a cross-section of the particle is sandwiched between arbitrary two parallel straight lines, the two straight lines are combined so as to maximize the distance between the two straight lines, and the distance between the two straight lines is measured as a particle size; and
(3) the observation image of the same sample is subjected to the same operation as above five times on different screens, and a value obtained from the number average for a total of 50 particles is then determined as an average particle size of the particles.

The content of the metal oxide particles is preferably 150 parts by mass or more, more preferably 250 parts by mass or more, further preferably 400 parts by mass or more, based on 100 parts by mass of the binder resin. When the content of the metal oxide particles is 150 parts by mass or more, the emissivity $\alpha$ of the optical laminate can be easily set to 0.75 or less. The content of high refractive index metal oxide particles such as ITO particles is preferably 150 parts by mass or more in that the refractive index of the layer comprising a metal oxide is increased, so that the reflectance of the optical laminate in a visible light region can be reduced by combination with an optionally formed low refractive index layer.

The content of the metal oxide particles is preferably 2000 parts by mass or less, more preferably 1500 parts by mass or less, further preferably 1200 parts by mass or less, still further preferably 1000 parts by mass or less, based on 100 parts by mass of the binder resin. When the content of the metal oxide particles is 2000 parts by mass or less, deterioration of coating film strength of the layer comprising a metal oxide can be easily suppressed. If the emissivity $\alpha$ of the optical laminate is excessively low, heat generated in an image display device is unlikely to be released to the outside. The content of the metal oxide particles is preferably 2000 parts by mass or less for preventing the emissivity $\alpha$ of the optical laminate from becoming excessively low.

The content of the metal oxide particles based on 100 parts by mass of the binder resin is preferably in the range of 150 parts by mass or more and 2000 parts by mass or less, 150 parts by mass or more and 1500 parts by mass or less, 150 parts by mass or more and 1200 parts by mass or less, 150 parts by mass or more and 1000 parts by mass or less, 250 parts by mass or more and 2000 parts by mass or less, 250 parts by mass or more and 1500 parts by mass or less, 250 parts by mass or more and 1200 parts by mass or less, 250 parts by mass or more and 1000 parts by mass or less, 400 parts by mass or more and 2000 parts by mass or less, 400 parts by mass or more and 1500 parts by mass or less, 400 parts by mass or more and 1200 parts by mass or less, or 400 parts by mass or more and 1000 parts by mass or less.

-Silane Coupling Agent-

The layer comprising metal oxide particles and a binder resin preferably comprises a silane coupling agent. The silane coupling agent may be a silane coupling agent as a surface treatment agent for the metal oxide particles, or a silane coupling agent as a binder resin.

When the metal oxide particles are subjected to surface treatment with a silane coupling agent, the affinity of the metal oxide particles to the binder resin is improved, so that the metal oxide particles are likely to be uniformly dispersed.

A case where the layer comprises a silane coupling agent as a binder resin is also preferable in that the metal oxide particles are likely to be uniformly dispersed.

Examples of the silane coupling agent include 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, tris-(trimethoxysilylpropyl)isocyanurate, 3-mercaptopropylmethyldimethoxysilane, 3-mercaptopropyltrimethoxysilane, 3-isocyanatepropyltriethoxysilane, methyltrimethoxysilane, dimethyldimethoxysilane, phenyltrimethoxysilane, methyltriethoxysilane, dimethyldimethoxysilane, phenyltrimethoxysilane, n-propyltrimethoxysilane, n-propyltriethoxysilane, hexyltrimethoxysilane, hexyltriethoxysilane, octyltriethoxysilane, decyltrimethoxysilane, 1,6-bis(trimethoxysilyl)hexane, trifluoropropyltrimethoxysilane, vinyltrimethoxysilane and vinyltriethoxysilane. In particular, one or more selected from the group consisting of 3-methacryloxypropylmethyldimethoxysilane, 3-methacryloxypropyltrimethoxysilane, 3-methacryloxypropylmethyldiethoxysilane and 3-methacryloxypropyltriethoxysilane are preferably used.

-Binder Resin-

The binder resin preferably comprises a cured product of a curable resin composition. Examples of the cured product of a curable resin composition include a cured product of a thermosetting resin composition, and a cured product of an ionizing radiation-curable resin composition, and a cured product of an ionizing radiation-curable resin composition is preferable for obtaining good mechanical strength.

The ratio of the cured product of the curable resin composition to the total binder resin of the layer comprising metal oxide particles is preferably 50 mass% or more, more preferably 70 mass% or more, further preferably 90 mass% or more, still further preferably 100 mass%.

The thermosetting resin composition is a composition comprising at least a thermosetting resin, and the resin composition is cured when heated.

Examples of the thermosetting resin include an acrylic resin, a urethane resin, a phenol resin, a urea melamine resin, an epoxy resin, an unsaturated polyester resin, and a silicone resin. In the thermosetting resin composition, a curing agent is added to the curable resin if necessary.

The ionizing radiation-curable resin composition is a composition comprising a compound having an ionizing radiation-curable functional group. In the present specification, the "compound having an ionizing radiation-curable functional group" is sometimes referred to as an "ionizing radiation-curable compound". Examples of the ionizing radiation-curable functional group include ethylenically unsaturated bond groups such as a (meth)acryloyl group, a vinyl group and an allyl group, an epoxy group, and an oxetanyl group. The ionizing radiation-curable compound is preferably a compound having an ethylenically unsaturated bond group, more preferably a compound having two or more ethylenically unsaturated bond groups, and in particular, a (meth)acrylate-based compound having two or more ethylenically unsaturated bond groups is further preferable. As the (meth)acrylate-based compound having two or more ethylenically unsaturated bond groups, either a monomer or an oligomer can be used.

The ionizing radiation means an electromagnetic wave or a charged particle radiation which has an energy quantum capable of polymerizing or crosslinking molecules. An ultraviolet ray or an electron beam is typically used, and in addition, an electromagnetic wave such as an X-ray or a $\gamma$-ray, or a charged particle radiation such as an $\alpha$-ray or an ion beam can be used.

In the present specification, the (meth)acrylate means acrylate or methacrylate, the (meth)acrylic acid means acrylic acid or methacrylic acid, and the (meth)acryloyl group means an acryloyl group or a methacryloyl group.

-Photopolymerization Initiator and Photopolymerization Accelerator-

When the ionizing radiation-curable compound is an ultraviolet ray-curable compound, the ionizing radiation-curable composition preferably comprises additives such as a photopolymerization initiator and a photopolymerization accelerator.

Examples of the photopolymerization initiator include one or more selected from the group consisting of acetophenone, benzophenone, $\alpha$-hydroxyalkylphenone, Michler's ketone, benzoin, benzyldimethylketal, benzoylbenzoate, $\alpha$-acyloxime esters, thioxanthones and the like.

The photopolymerization accelerator is capable of increasing the curing rate by relieving inhibition of polymerization by air during curing, and examples thereof include one or more selected from the group consisting of isoamyl p-dimethylaminobenzoate ester, ethyl p-dimethylaminobenzoate and the like.

-Diffractive Index and Film Thickness-

The diffractive index of the layer comprising metal oxide particles and a binder resin is preferably 1.53 or more and 2.30 or less, more preferably 1.57 or more and 2.00 or less, more preferably 1.60 or more and 1.80 or less, more preferably 1.65 or more and 1.75 or less. When the refractive index of the layer comprising a metal oxide is in any of the above-described ranges, the reflectance of the optical laminate in a visible light region can be easily reduced by combination with an optionally formed low refractive index layer.

The refractive index of the layer comprising metal oxide particles and a binder resin is preferably in the range of 1.53 or more and 2.30 or less, 1.53 or more and 2.00 or less, 1.53 or more and 1.80 or less, 1.53 or more and 1.75 or less, 1.57 or more and 2.30 or less, 1.57 or more and 2.00 or less, 1.57 or more and 1.80 or less, 1.57 or more and 1.75 or less, 1.60 or more and 2.30 or less, 1.60 or more and 2.00 or less, 1,60 or more and 1.80 or less, 1.60 or more and 1.75 or less, 1.65 or more and 2.30 or less, 1.65 or more and 2.00 or less, 1.65 or more and 1.80 or less, or 1.65 or more and 1.75 or less.

In the present specification, the refractive index of each layer means a refractive index at a wavelength of 550 nm. The refractive index of each layer can be herein calculated by, for example, fitting of the reflectance spectrum measured with a reflection photometer and the reflectance spectrum calculated from an optical model of a multilayer thin film using the Fresnel coefficient.

The thickness of the layer comprising metal oxide particles and a binder resin is preferably 100 nm or more, more preferably 200 nm or more, further preferably 500 nm or more, for easily setting the emissivity $\alpha$ to 0.75 or less.

There is limitation on reduction of the emissivity $\alpha$ by increasing the thickness of the layer comprising metal oxide particles and a binder resin. If the thickness of the layer comprising metal oxide particles and a binder resin is excessively large, transparence tends to be deteriorated. The thickness of the layer comprising metal oxide particles and a binder resin is preferably 5.0 $\mu$m or less, more preferably 2.0 $\mu$m or less, further preferably 1.5 $\mu$m or less, for thinning the film.

The thickness of the layer comprising metal oxide particles and a binder resin is preferably in the range of 100 nm or more and 5.0 $\mu$m or less, 100 nm or more and 2.0 $\mu$m or less, 100 nm or more and 1.5 $\mu$m or less, 200 nm or more and 5.0 $\mu$m or less, 200 nm or more and 2.0 $\mu$m or less, 200 nm or more and 1.5 $\mu$m or less, 500 nm or more and 5.0 $\mu$m or less, 500 nm or more and 2.0 $\mu$m or less, or 500 nm or more and 1.5 $\mu$m or less.

For reducing the reflectance in a visible light region by elimination of interference waves by combination with an optionally formed low refractive index layer, the thickness of the layer comprising metal oxide particles and a binder resin is preferably adjusted in consideration of $n_o$ representing a refractive index of the layer comprising metal oxide particles and a binder resin. Specifically, the layer comprising metal oxide particles and a binder resin is preferably adjusted to a thickness close to an integral multiple of "550 nm/$2n_o$". The range of the thickness of the layer comprising metal oxide particles and a binder resin, which is adjusted to reduce the reflectance in a visible light region, varies depending on the refractive index range and therefore is hard to define as described above, and the thickness is preferably 120 nm or more and 750 nm or less, more preferably 130 nm or more and 500 nm or less, further preferably 140 nm or more and 400 nm or less.

For reducing the reflectance in a visible light region, the thickness of the layer comprising metal oxide particles and a binder resin is preferably in the range of 120 nm or more and 750 nm or less, 120 nm or more and 500 nm or less, 120 nm or more and 400 nm or less, 130 nm or more and 750 nm or less, 130 nm or more and 500 nm or less, 130 nm or more and 400 nm or less, 140 nm or more and 750 nm or less, 140 nm or more and 500 nm or less, or 140 nm or more and 400 nm or less.

The layer comprising metal oxide particles and a binder resin may comprise additives such as a leveling agent, a dispersant, a dye, an ultraviolet ray absorbent, a light stabilizer and an antioxidant as long as the effects of the present disclosure are not hindered.

The layer comprising metal oxide particles and a binder resin can be formed by, for example, applying a coating solution, in which components for forming the layer is dispersed or dissolved, onto a plastic film or the like, drying the applied coating solution, and then performing irradiation with an ionizing radiation if necessary.

The layer comprising metal oxide particles and a binder resin is preferably subjected to heating treatment after the layer is formed as described above. The heating treatment enables the emissivity $\alpha$ to be easily reduced.

The heating treatment temperature is preferably 90°C or higher, more preferably 95°C or higher, further preferably 100°C or higher for the lower limit, and preferably 170°C or lower, more preferably 160°C or lower, further preferably 150°C or lower for the upper limit.

The heating treatment temperature is preferably 30 minutes or more, more preferably 45 minutes or more, further preferably 50 minutes or more for the lower limit, and preferably 200 minutes or less, more preferably 120 minutes or less, further preferably 80 minutes or less for the upper limit.

«(2) Metal Oxide Film»

The metal oxide film is obtained by depositing a metal oxide by, for example, a physical vapor deposition method such as sputtering or a chemical vapor deposition method. Among the metal oxide films, an indium tin oxide film which allows the emissivity to be easily reduced is preferable.

The metal oxide film is preferably amorphous for easily setting the emissivity $\alpha$ of the optical laminate to 0.27 or more. That is, the metal oxide film is preferably one that has not been subjected crystallization treatment by heating, such as annealing treatment. An amorphous metal oxide film is preferable in that it has good flex resistance, and is easily applied to a foldable image display device and a rollable image display device.

For these reasons, the metal oxide film is preferably an amorphous film of indium tin oxide.

-Refractive Index and Film Thickness-

The refractive index of the metal oxide film is preferably 2.0 or more and 2.5 or less, more preferably 2.1 or more and 2.2 or less. When the refractive index of the metal oxide film is in any of the above-described ranges, the reflectance of the optical laminate in a visible light region can be easily reduced by combination with an optionally formed low refractive index layer.

The refractive index of the metal oxide film is preferably in the range of 2.0 or more and 2.2 or less, or 2.1 or more and 2.5 or less as well as in any of the above-described ranges.

The thickness of the metal oxide film is preferably 10 nm or more, more preferably 20 nm or more, further preferably 30 nm or more, for easily setting the emissivity $\alpha$ to 0.75 or less. The degree to which a layer having a low emissivity repels out radiation heat tends to become higher as the thickness increases. Thus, the thickness of the metal oxide film is preferably 100 nm or more for suppressing a rise in temperature of the optical laminate.

The transparency tends to be deteriorated if the thickness of the metal oxide film is excessively large. For thinning the film, the thickness of the metal oxide film is preferably 1000 nm or less, more preferably 500 nm or less, further preferably 300 nm or less.

The thickness of the metal oxide film is preferably in the range of 10 nm or more and 1000 nm or less, 10 nm or more and 500 nm or less, 10 nm or more and 300 nm or less, 20 nm or more and 1000 nm or less, 20 nm or more and 500 nm or less, 20 nm or more and 300 nm or less, 30 nm or more and 1000 nm or less, 30 nm or more and 500 nm or less, or 30 nm or more and 300 nm or less.

For easily applying the metal oxide film to a foldable image display device and a rollable image display device, the thickness of the metal oxide film is preferably 30 nm or more and 250 nm or less, more preferably 30 nm or more and 150 nm or less.

For reducing the reflectance in a visible light region by combination with an optionally formed low refractive index layer, the thickness of the metal oxide film is preferably 100 nm or more and 200 nm or less, more preferably 100 nm or more and 170 nm or less, further preferably 100 nm or more and 140 nm or less.

<Functional Layer $\alpha$>

The optical laminate may comprise at least one functional layer $\alpha$ between the plastic film and the layer comprising a metal oxide.

Examples of the functional layer $\alpha$ include a hardcoat layer, a high refractive index layer, a medium refractive index layer, a low refractive index layer, an antiglare layer, an antistatic layer, and a circular polarization layer, and a single-layered hardcoat layer is preferable.

<<Hardcoat Layer>>

The optical laminate preferably comprises a hardcoat layer as the functional layer $\alpha$ for enhancing scratch resistance and pencil hardness.

The hardcoat layer preferably comprises a resin component. The resin component of the hardcoat layer preferably comprises a cured product of a curable resin composition as a main component. The main component means 50 mass% or more, preferably 70 mass% or more, more preferably 90 mass% or more, further preferably 100 mass%, of the total resin of the hardcoat layer.

Examples of the cured product of a curable resin composition include a cured product of a thermosetting resin composition, and a cured product of an ionizing radiation-curable resin composition, and a cured product of an ionizing radiation-curable resin composition is preferable for obtaining better mechanical strength.

Examples of the curable resin composition of the hardcoat layer include the curable resin compositions exemplified for the layer comprising a metal oxide.

The hardcoat layer may comprise additives such as an ultraviolet ray absorbent, a light stabilizer, an antioxidant and a refractive index modifier.

For easily obtaining good scratch resistance, the thickness of the hardcoat layer is preferably 0.1 μm or more, more preferably 0.5 μm or more, more preferably 1.0 μm or more, more preferably 2.0 μm or more. For suppressing retention of heat and suppressing curling, the thickness of the hardcoat layer is preferably 100 μm or less, more preferably 50 μm or less, more preferably 30 μm or less, more preferably 20 μm or less, more preferably 15 μm or less, more preferably 10 μm or less.

The thickness of the hardcoat layer is preferably in the range of 0.1 μm or more and 100 μm or less, 0.1 μm or more and 50 μm or less, 0.1 μm or more and 30 μm or less, 0.1 μm or more and 20 μm or less, 0.1 μm or more and 15 μm or less, 0.1 μm or more and 10 μm or less, 0.5 μm or more and 100 μm or less, 0.5 μm or more and 50 μm or less, 0.5 μm or more and 30 μm or less, 0.5 μm or more and 20 μm or less, 0.5 μm or more and 15 μm or less, 0.5 μm or more and 10 μm or less, 1.0 μm or more and 100 μm or less, 1.0 μm or more and 50 μm or less, 1.0 μm or more and 30 μm or less, 1.0 μm or more and 20 μm or less, 1.0 μm or more and 15 μm or less, 1.0 μm or more and 10 μm or less, 2.0 μm or more and 100 μm or less, 2.0 μm or more and 50 μm or less, 2.0 μm or more and 30 μm or less, 2.0 μm or more and 20 μm or less, 2.0 μm or more and 15 μm or less, or 2.0 μm or more and 10 μm or less.

<Functional Layer β>

The optical laminate may comprise at least one functional layer β on the layer comprising a metal oxide, side opposite to the plastic film.

Examples of the functional layer β include a low refractive index layer, a high refractive index layer, an antiglare layer, an antifouling layer, and a circular polarization layer. The functional layer may also have the aforementioned functions. For example, the low refractive index layer may have an antifouling property or an antiglare property.

The total thickness of the at least one functional layer β is preferably 1000 nm or less, more preferably 500 nm or less, more preferably 350 nm or less, more preferably 200 nm or less, more preferably 150 nm or less.

The temperature of the layer located on a side opposite to the plastic film with respect to the layer comprising a metal oxide is raised by radiation heat outside the image display device and radiation heat generated from the inside of the image display device and transmitted through the layer comprising a metal oxide. Thus, it tends to become more likely that the at least one functional layer β retains heat as the total thickness of the at least one functional layer β increases. Thus, when the total thickness of the at least one functional layer β is 350 nm or less, the optical laminate can be easily inhibited from being subjected to high temperature. When the total thickness of the at least one functional layer β is 350 nm or less, the emissivity α can be easily reduced.

Given that the total thickness of the at least one functional layer β is preferably small, the functional layer β is preferably a single layer, more preferably a single-layered low refractive index layer.

«Low Refractive Index Layer»

The low refractive index layer is preferably located on an outermost surface on a side opposite to the plastic film with respect to the layer comprising a metal oxide.

The refractive index of the low refractive index layer is preferably 1.10 or more and 1.48 or less, more preferably 1.20 or more and 1.45 or less, more preferably 1.26 or more and 1.40 or less, more preferably 1.28 or more and 1.38 or less, more preferably 1.30 or more and 1.32 or less.

The refractive index of the low refractive index layer is preferably in the range of 1.10 or more and 1.48 or less, 1.10 or more and 1.45 or less, 1.10 or more and 1.40 or less, 1.10 or more and 1.38 or less, 1.10 or more and 1.32 or less, 1.20 or more and 1.48 or less, 1.20 or more and 1.45 or less, 1.20 or more and 1.40 or less, 1.20 or more and 1.38 or less, 1.20 or more and 1.32 or less, 1.26 or more and 1.48 or less, 1.26 or more and 1.45 or less, 1.26 or more and 1.40 or less, 1.26 or more and 1.38 or less, 1.26 or more and 1.32 or less, 1.28 or more and 1.48 or less, 1.28 or more and 1.45 or less, 1.28 or more and 1.40 or less, 1.28 or more and 1.38 or less, 1.28 or more and 1.32 or less, 1.30 or more and 1.48 or less, 1.30 or more and 1.45 or less, 1.30 or more and 1.40 or less, 1.30 or more and 1.38 or less, or 1.30 or more and 1.32 or less.

The thickness of the low refractive index layer is 80 nm or more and 150 nm or less, more preferably 85 nm or more and 110 nm or less, more preferably 90 nm or more and 105 nm or less. The thickness of the low refractive index layer is preferably larger than the average particle size of low refractive index particles such as hollow particles.

The thickness of the low refractive index layer is preferably in the range of 80 nm or more and 150 nm or less, 80 nm or more and 110 nm or less, 80 nm or more and 105 nm or less, 85 nm or more and 150 nm or less, 85 nm or more and 110 nm or less, 85 nm or more and 105 nm or less, 90 nm or more and 150 nm or less, 90 nm or more and 110 nm or less, or 90 nm or more and 105 nm or less. It is more preferable that the thickness of the low refractive index layer satisfy the above-described preferred range and the thickness of the low refractive index layer be larger than the average particle size of low refractive index particles such as hollow particles.

Methods for forming a low refractive index layer can be broadly classified into wet methods and dry methods. Examples of the wet method include a method in which a low refractive index layer is formed by a sol-gel method using a metal alkoxide or the like; a method in which a resin having a low refractive index, such as fluororesin, is applied to form a low refractive index layer; and a method in which a coating solution for forming a low refractive index layer, in which low refractive index particles are contained in a resin composition, is applied to form a low refractive index layer. Examples of the dry method include a method in which particles having a desired refractive index are selected from low refractive index particles, and a low refractive index layer is formed by a physical vapor deposition method or a chemical vapor deposition method.

The wet method is superior to the dry method in terms of production efficiency, suppression of a slanted reflection color phase and chemical resistance. In the present embodiment, among the wet methods, formation using a coating solution for forming a low refractive index layer, in which low refractive index particles are contained in a binder resin composition, is preferable for adhesion, water resistance, scratch resistance and reduction of the refractive index. In other words, the low refractive index layer preferably comprises a binder resin and low refractive index particles.

The binder resin of the low refractive index layer preferably comprises a cured product of a curable resin composition. The ratio of the cured product of a curable resin composition to the total binder resin of the low refractive index layer is preferably 10 mass% or more, more preferably 30 mass% or more, more preferably 50 mass% or more, more preferably 70 mass% or more, more preferably 90 mass% or more, most preferably 100 mass%.

Examples of the curable resin composition of the low refractive index layer include the curable resin compositions exemplified for the layer comprising a metal oxide.

The low refractive index particle preferably comprises one or more selected from the group consisting of hollow particles and non-hollow particles. For balancing between low reflection and scratch resistance, it is preferable that one or more selected from the group consisting of hollow particles be used in combination with one or more selected from the group consisting of non-hollow particles.

The material for each of the hollow particle and the non-hollow particle may be either an inorganic compound such as silica or magnesium fluoride, or an organic compound, and silica is preferable for reduction of the refractive index, and strength.

The average particle size of hollow silica particles is preferably 50 nm or more and 200 nm or less, more preferably 60 nm or more and 80 nm or less in consideration of optical properties and mechanical strength. The average particle size of the hollow silica particles is preferably in the range of 50 nm or more and 80 nm or less or 60 nm or more and 200 nm or less as well as in any of the above-described ranges.

The average particle size of the non-hollow silica particles is preferably 5 nm or more and 100 nm or less, more preferably 10 nm or more and 20 nm or less, for prevention of aggregation of the non-hollow silica particles and in consideration of the dispersibility thereof. The average particle size of the non-hollow silica particles is preferably in the range of 5 nm or more and 20 nm or less or 10 nm or more and 100 nm or less as well as in any of the above-described ranges.

The rate of packing of the hollow silica particles in the binder resin increases and the refractive index of the low refractive index layer decreases as the content of the hollow silica particles increases. Thus, the content of the hollow silica particles is preferably 100 parts by mass or more, more preferably 150 parts by mass or more, based on 100 parts by mass of the binder resin.

On the other hand, if the content of the hollow silica particles with respect to the binder resin is excessively high, the amount of hollow silica particles exposed from the binder resin increases, and the amount of the binder resin for bonding the particles decreases. Consequently, the hollow silica particles are likely to be damaged or fall off, and mechanical strength such as scratch resistance, of the low refractive index layer tends to be deteriorated. Thus, the content of the hollow silica particles is preferably 400 parts by mass or less, more preferably 300 parts by mass or less, based on 100 parts by mass of the binder resin.

The content of the hollow silica particles based on 100 pars by mass of the binder resin is preferably in the range of 100 parts by mass or more and 400 parts by mass or less, 100 parts by mass or more and 300 parts by mass or less, 150 parts by mass or more and 400 parts by mass or less, or 150 parts by mass or more and 300 parts by mass or less.

If the content of the non-hollow silica particles is low, there may be no influence on an increase in hardness even in the presence of the non-hollow silica particles in the surface of the low refractive index layer. When the non-hollow silica particles are contained in a large amount, the influence of the variation in shrinkage due to polymerization of the binder resin decreases, so that the asperity occurring on the low refractive index surface after curing the resin can be decreased. Thus, the content of the non-hollow silica particles is preferably 10 parts by mass or more, more preferably 50 parts by mass or more, more preferably 70 parts by mass or more, more preferably 100 parts by mass or more, based on 100 parts by mass of the binder resin.

On the other hand, if the content of the non-hollow silica particles is excessively high, the non-hollow silica particles are likely to be aggregated, so that a variation in shrinkage of the binder resin occurs, leading to an increase in asperity on the surface. Thus, the content of the non-hollow silica particles is preferably 200 parts by mass or less, more preferably 150 parts by mass or less, based on 100 parts by mass or the binder resin.

The content of the non-hollow silica particles based on 100 parts by mass of the binder resin is preferably in the range of 10 parts by mass or more and 200 parts by mass or less, 10 parts by mass or more and 150 parts by mass or less, 50 parts by mass or more and 200 parts by mass or less, 50 parts by mass or more and 150 parts by mass or less, 70 parts by mas or more and 200 parts by mass or less, 70 parts by mass or more and 150 parts by mass or less, 100 parts by mass or more and 200 parts by mass or less, or 100 parts by mass or more and 150 parts by mass or less.

When the hollow silica particles and the non-hollow silica particles are contained at the above-described respective proportions in the binder resin, the barrier properties of the low refractive index layer can be improved. It is presumed that the silica particles are uniformly dispersed at a high rate of packing and thus passage of gases and the like is inhibited.

A cosmetic product such as a sunscreen or a hand cream may comprise a low molecular weight polymer low in volatility. When the low refractive index layer has good barrier properties, the low molecular weight polymer can be inhibited from penetrating into the coating film of the low refractive index layer, and any failure such as appearance abnormality due to the long-term remaining of the low molecular weight polymer in the coating film can be suppressed. Suppression of penetration of the low molecular weight polymer into the coating film of the low refractive index layer is also preferable for reducing the emissivity $\alpha$.

<Emissivity>

The emissivity of the optical laminate of the present disclosure for light with a wavelength range of 2000 nm or more and 22000 nm or less is required to be 0.27 or more and 0.75 or less as measured from the side of the layer comprising a metal oxide with respect to the plastic film. In the present specification, the emissivity is sometimes referred to as an "emissivity $\alpha$" as described above.

If the emissivity $\alpha$ is more than 0.75, the optical laminate absorbs radiation heat resulting from an external environment such as a temperature of the interior of a vehicle, so that the visibility of an image display device comprising the optical laminate is deteriorated.

If the emissivity $\alpha$ is less than 0.27, radiation heat generated in the image display device is returned into the image display device by the optical laminate, so that the inside of the image display device is subjected to high temperature, resulting in deterioration of the visibility of the image display device comprising the optical laminate. Examples of the radiation heat generated in the image display device include radiation heat generated from a display element.

The emissivity $\alpha$ is preferably 0.35 or more and 0.70 or less, more preferably 0.37 or more and 0.67 or less, further preferably 0.40 or more and 0.60 or less.

With the improvement in display technology in recent years, for example, a flexible optical laminate may be desired for imparting a curved surface property to a display to improve the design property. If the emissivity $\alpha$ is less than 0.40, the layer comprising a metal oxide may be likely to harden, leading to occurrence of a problem in curved surface formability. Thus, an emissivity $\alpha$ of 0.40 or more is preferable for curved surface formability. The emissivity $\alpha$ is preferably as low as possible because a temperature rise resulting from an external environment can be controlled. Thus, for example, an emissivity $\alpha$ of 0.60 or less is preferable in that the sensory temperature when a face or a hand is kept close to the image display device for a long time can be easily lowered because the surface temperature of the optical laminate can be easily made low enough to touch the optical laminate surface with the hand without difficulty and the optical laminate itself can be easily inhibiting from acting as a heat source.

The emissivity $\alpha$ is preferably in the range of 0.27 or more and 0.75 or less, 0.27 or more and 0.70 or less, 0.27 or more and 0.67 or less, 0.27 or more and 0.60 or less, 0.35 or more and 0.75 or less, 0.35 or more and 0.70 or less, 0.35 or more and 0.67 or less, 0.35 or more and 0.60 or less, 0.37 or more and 0.75 or less, 0.37 or more and 0.70 or less, 0.37 or more and 0.67 or less, 0.37 or more and 0.60 or less, 0.40 or more and 0.75 or less, 0.40 or more and 0.70 or less, 0.40 or more and 0.67 or less, or 0.40 or more and 0.60 or less.

In the present specification, the deterioration of visibility means, for example, that "various kinds of performance such as lightness, color and reflection direction characteristics are uneven in limited portions within the display screen of the image display device", "the various kinds of performance are uneven between the vicinity of the center and the vicinity of an end of the display screen of the image display device" or "the various kinds of performance in a high-temperature environment are different from those in a normal-temperature environment".

Such deterioration of visibility may occur due to, for example, heat-induced deformation of the optical laminate.

An image display device typically comprises cooling means such as an air-cooling fan, and the cooling effect of the cooling means varies depending on a location in the image display device. Radiation heat is continuously generated, and therefore the aforementioned difference in cooling effect is gradually accumulated, so that the temperature varies depending on a location in the image display device. Thus, within a surface of the optical laminate, there may be portions different in temperature, and in such a case, the optical laminate may undergo a local change in physical properties, resulting in deterioration of visibility.

The optical laminate of the present disclosure is capable of suppressing deterioration of visibility which is caused as described above.

In the present specification, the emissivity $\alpha$ means an emissivity at normal temperature which is measured in accordance with JIS A1423: 1983. Examples of the apparatus for measuring the emissivity include Model "TSS-5X-2" manufactured by Japan Sensor Corporation.

In the present specification, various physical properties such as an emissivity, a spectral transmittance, a luminous reflectance Y value, a total light transmittance and a haze are those obtained by exposing a measurement sample to an environment at a temperature of 23 $\pm$ 5°C and a relative humidity of 40% or more and 65% or less for 30 minutes or more, followed by measurement in the same environment unless otherwise specified.

In the present specification, various physical properties such as an emissivity, a spectral transmittance, a luminous reflectance Y value, a total light transmittance and a haze are each determined as an average value of 20 measurements unless otherwise specified.

<Physical Properties>

The average of spectral transmittance of the layer comprising a metal oxide in a wavelength range of 8200 nm or more and 9000 nm or less is preferably 80% or less, more preferably 70% or less, further preferably 60% or less.

The following expression (1) indicates a peak wavelength ($\lambda$) of a radiation wavelength emitted by a blackbody at a certain temperature, and is called Wien's equation. In the expression, "T" represents a temperature in the unit of °C.

$$\lambda \ (\mathrm{nm}) = 2897/(\mathrm{T} + 273) \ (1)$$

For example, the temperatures of the atmosphere of the interior and a dashboard of an automobile in the summer and the temperature at the window in a closed room in the summer are each said to be about 50°C or higher and 80°C or lower. By assigning 50 and 80 to T in the above expression, values of about 9000 nm and about 8200 nm, respectively, are obtained as $\lambda$.

That is, the wavelength range for the spectral transmittance is specified as 8200 nm or more and 9000 or less in consideration of the temperature of an automobile in the summer and the temperature at the window in a closed room in the summer. Thus, when the average of the spectral transmittance is 80% or less, the optical laminate efficiently cuts an infrared ray emitted from the interior of an automobile, and therefore the image display device can be further inhibited from being subjected to high temperature, so that deterioration of visibility can be more easily suppressed.

The lower limit of the average of the spectral transmittance is not particularly limited, and is typically 30% or more, preferably 40% or more.

In the present specification, the spectral transmittance of the layer comprising a metal oxide means a value calculated through the following measurement (A1) and transformation (A2).

(A1) The absorbance of the layer comprising a metal oxide at each wavelength is measured by reflection in FTIR.
(A2) The absorbance at each wavelength in A1 is transformed into a transmittance at each wavelength.

The measurement (A1) is performed on the side of the layer comprising a metal oxide with respect to the plastic film. Even in the presence of the functional layer $\beta$ on the layer comprising a metal oxide, the measurement (A1) can be performed in the presence of the functional layer $\beta$ as long as the total thickness of the functional layer $\beta$ is about 250 nm or less. The absorbance of the layer comprising a metal oxide, which has been measured in the presence of the functional layer $\beta$, is transformed in (A2). In this way, the spectral transmittance of the layer comprising a metal oxide can be calculated.

The luminous reflectance Y value of the optical laminate which is measured from the side of the layer comprising a metal oxide with respect to the plastic film is preferably 2.0% or less, more preferably 1.0% or less, further preferably 0.5% or less.

In the present specification, the luminous reflectance Y value refers to a luminous reflectance Y value in the CIE 1931 standard color system, and is determined at an incidence angle of 5 degrees.

The luminous reflectance Y value can be calculated using a spectrophotometer. Examples of the spectrophotometer include trade name "UV-2450" manufactured by Shimadzu Corporation.

It is preferable to bond a black plate to the back surface of the plastic film in measurement of the luminous reflectance.

The JIS K7361-1: 1997-specified total light transmittance of the optical laminate is preferably 70% or more, more preferably 80% or more, further preferably 90% or more.

The JIS K7136-1: 2000-specified haze of the optical laminate is preferably 5% or less, more preferably 3% or less, further preferably 1% or less.

The light incidence surface used for measuring the total light transmittance and the haze is preferably a surface on the plastic film side with respect to the layer comprising a metal oxide.

In the optical laminate, the roughness of an outermost surface on the side of the layer comprising a metal oxide with respect to the plastic film is preferably in a predetermined range.

Specifically, the JIS B0601: 2001-specified arithmetic average roughness Ra of the outermost surface at a cutoff value of 2.5 mm is preferably 3 $\mu$m or less, more preferably 1 $\mu$m or less, further preferably 0.1 $\mu$m or less. When Ra is 3 $\mu$m or less, the emissivity $\alpha$ can be easily set to 0.75 or less.

When Ra is measured, it is preferable to set the lateral magnification to 1000 times and set the longitudinal magnification to 20000 times as measurement conditions in the measurement apparatus.

<Layer Configuration>

The overall layer structure of the optical laminate of the present disclosure is not particularly limited, and examples thereof include the following (1) to (6). It is to be noted that "/" denotes the interface between layers.

    (1) plastic film/layer comprising a metal oxide
    (2) plastic film/hardcoat layer/layer comprising a metal oxide
    (3) plastic film/layer comprising a metal oxide/low refractive index layer
    (4) plastic film/hardcoat layer/layer comprising a metal oxide/low refractive index layer
    (5) plastic film/layer comprising a metal oxide/high refractive index layer/low refractive index layer
    (6) plastic film/hardcoat layer/layer comprising a metal oxide/high refractive index layer/low refractive index layer.

<Total Thickness>

The total thickness of the optical laminate is preferably 10 $\mu$m or more, more preferably 30 $\mu$m or more, further preferably 45 $\mu$m or more for obtaining good mechanical strength. For easily applying the optical laminate to a foldable image display device and a rollable image display device, the total thickness of the optical laminate is preferably 130 $\mu$m or less, more preferably 100 $\mu$m or less, further preferably 90 $\mu$m or less, still further preferably 75 $\mu$m or less.

The total thickness of the optical laminate is preferably in the range of 10 $\mu$m or more and 130 $\mu$m or less, 10 $\mu$m or more and 100 $\mu$m or less, 10 $\mu$m or more and 90 $\mu$m or less, 10 $\mu$m or more and 75 $\mu$m or less, 30 $\mu$m or more and 130 $\mu$m or less, 30 $\mu$m or more and 100 $\mu$m or less, 30 $\mu$m or more and 90 $\mu$m or less, 30 $\mu$m or more and 75 $\mu$m or less, 45 $\mu$m or more and 130 $\mu$m, 45 $\mu$m or more and 100 $\mu$m or less, 45 $\mu$m or more and 90 $\mu$m or less, or 45 $\mu$m or more and 75 $\mu$m or less.

When the total thickness of the optical laminate is in any of the above-described ranges, a value of $\phi$10 mm or less can be easily achieved in evaluation with an outward bending mandrel test bar. An optical laminate having a total thickness of 75 $\mu$m or less, among the above-described ranges, enables even a value of $\phi$6 mm or less to be easily achieved. That is, when the total thickness of the optical laminate is in any of the above-described ranges, the optical laminate can be easily applied to a foldable image display device and a rollable image display device. The term "outward bending" means that bending is performed so that the side of the layer comprising a metal oxide with respect to the plastic film faces outside. The term "outside" means a "side more remote from the mandrel bar".

[Polarizing Plate]

The polarizing plate of the present disclosure comprises a polarizer, a first transparent protection plate disposed on one side of the polarizer, and a second transparent protection plate disposed on the other side of the polarizer, wherein at least one selected from the group consisting of the first transparent protection plate and the second transparent protection plate is the above-described optical laminate of the present disclosure.

<Polarizer>

Examples of the polarizer include a sheet-type polarizer such as a polyvinyl alcohol film, a polyvinyl formal film, a polyvinyl acetal film, and an ethylenevinyl acetate copolymer-based saponified film which are dyed with iodine or the like and are stretched, a wire grid-type polarizer formed from a large number of metal wires arranged in parallel, a coating-type polarizer coated with a lyotropic liquid crystal or a dichroic guest-host material, and a multilayer thin film-type polarizer. Such a polarizer may be a reflection-type polarizer having a function of reflecting a non-transmission

EP 4 123 344 A1

polarizing component.

<Transparent Protection Plate>

The first transparent protection plate is disposed on one side of the polarizer, and the second transparent protection plate is disposed on the other side. At least one of the first transparent protection plate and the second transparent protection plate is the above-described optical laminate of the present disclosure.
The optical laminate is preferably disposed such that a surface on the plastic film side with respect to the layer comprising a metal oxide faces the polarizer side.
Examples of the first transparent protection plate and the second transparent protection plate other than the optical laminate include a plastic film and glass, and a plastic film is preferable.
Examples of the plastic film include a polyester film, a polycarbonate film, a cycloolefin polymer film, an acrylic film, and a triacetyl cellulose film, and stretched films thereof are preferable for the mechanical strength.
It is preferable to bond the polarizer to the transparent protection plate with an adhesive interposed therebetween. As the adhesive, a common adhesive can be used, and a PVA-based adhesive is preferable.
In the polarizing plate of the present disclosure, both the first transparent protection plate and the second transparent protection plate may be the above-described optical laminate of the present disclosure, and it is preferable that one of the first transparent protection plate and the second transparent protection plate be the optical laminate of the present disclosure. When the polarizing plate of the present disclosure is used as a polarizing plate disposed on the light emission surface of the display element, it is preferable that a transparent protection plate on the light emission surface of the polarizer be the above-described optical laminate of the present disclosure.

[Surface Plate for Image Display Device]

The surface plate for an image display device according to the present disclosure is one obtained by bonding the above-described optical laminate of the present disclosure onto a resin plate or a glass plate.
The optical laminate is preferably disposed such that a surface on the plastic film side with respect to the layer comprising a metal oxide faces the resin plate or the glass plate side.
The surface plate for an image display device is preferably disposed such that a surface on the bonded optical laminate side faces the surface side. In other words, the surface plate for an image display device is preferably disposed such that a surface on the bonded optical laminate side faces a side opposite to the display element.
As the resin plate or the glass plate, a resin plate or a glass plate which is commonly used as a surface plate for an image display device can be used.
The thickness of the resin plate or the glass plate is preferably 10 μm or more for obtaining good strength. The upper limit of the thickness of the resin plate or the glass plate is typically 5000 μm or less, and is preferably 1000 μm or less, more preferably 500 μm or less, further preferably 100 μm or less because it has been preferred to thin an image display device in recent years.
The thickness of the resin plate or the glass plate is preferably in the range of 10 μm or more and 5000 μm or less, 10 μm or more and 1000 μm or less, 10 μm or more and 500 μm or less, or 10 μm or more and 100 μm or less.

[Image Display Device]

The image display device of the present disclosure has the above-described optical laminate of the present disclosure on the light emission surface of the display element.
The optical laminate is preferably disposed such that a surface on the side of the layer comprising a metal oxide with respect to the plastic film faces a side opposite to the display element.
The optical laminate is preferably disposed on an outermost surface of the image display device.
For suppressing heat conduction, the optical laminate is preferably disposed such that air is interposed between the display element and the optical laminate in the image display device.
Examples of the display element include a liquid crystal display element, an EL display element such as an organic EL display element and an inorganic EL display element, a plasma display element, and a LED display element such as a micro LED display element and a mini LED display element. These display elements may have a touch panel function in the display element.
Examples of the liquid crystal display mode of the liquid crystal display element include IPS mode, VA mode, multi-domain mode, OCB mode, STN mode, and TSTN mode. When the display element is a liquid crystal display element, a backlight is required. The backlight is disposed on the liquid crystal display element, the back light being on a side opposite to the optical laminate.
The image display device may be a foldable image display device or a rollable image display device. The image

14

display device may be an image display device with a touch panel.

A portable image display device and an image display device installed in a dashboard of an automobile are preferable in that the effects of the present disclosure are easily exhibited because the image display devices are likely to be exposed to a high-temperature environment.

The image display device preferably has a common heat dissipation mechanism on the display element, the heat dissipation mechanism being on a side opposite to the light emission surface. Examples of the common heat dissipation mechanism include an air-cooling fan, a heat dissipation fin, a heat pump, and a Peltier element.

Examples

Hereinafter, the present disclosure will be described in detail by showing Examples and Comparative Examples. The present disclosure is not limited to forms described in Examples.

1. Evaluation and Measurement

The optical laminates obtained in Examples and Comparative Examples were measured and evaluated in the following manners. Table 1 shows the results. Unless particularly denoted, the atmosphere in each measurement and evaluation was at a temperature of 23 ± 5°C and a relative humidity of 40% or more and 65% or less, and a specimen of interest was exposed to the atmosphere for 30 minutes or more before the start of each measurement and evaluation, and then subjected to measurement and evaluation.

The optical laminate of Comparative Example 2 does not have a layer comprising a metal oxide. Thus, for Comparative Example 2, the following evaluations and measurements are performed with the heat dissipation layer of Comparative Example 2 likened to the layer comprising a metal oxide.

1-1. Emissivity

For the optical laminates of Examples and Comparative Examples, the emissivity at normal temperature was measured in accordance with JIS A1423: 1983. Specifically, "the emissivity of the optical laminate for light with a wavelength range of 2000 nm or more and 22000 nm or less was measured from the side of the layer comprising a metal oxide with respect to the substrate". In the present specification, the emissivity is sometimes referred to as an "emissivity $\alpha$" as described above.

A specimen having an emissivity $\alpha$ of more than 0.75 was rated C. A specimen having an emissivity $\alpha$ of less than 0.27 was rated B. A specimen having an emissivity $\alpha$ of 0.27 or more and 0.75 or less was rated A or higher, and in particularly, a specimen having an emissivity $\alpha$ of 0.37 or more and 0.60 or less was rated AA.

If the emissivity $\alpha$ is excessively high, the temperature of the image display device rises because the optical laminate absorbs radiation heat resulting from an external environment. On the other hand, if the emissivity $\alpha$ is excessively low, the optical laminate is less likely to absorb radiation heat resulting from an external environment, but the inside of the image display device may be subjected to high temperature because the radiation heat generated in the image display device is returned into the image display device by the optical laminate.

Model "TSS-5X-2" manufactured by Japan Sensor Corporation was used as an emissivity measurement device. There are two types of emissivity reference pieces attached to the measurement device, where one has an emissivity of 0.06 and the other has an emissivity of 0.97. The main specs of the measurement device are as follows.

<Specs>

- Measurement area: $\phi$15 mm
- Measurement distance: 12 mm

1-2. Spectral Transmittance

For the optical laminates of Examples and Comparative Examples, the spectral transmittance of the layer comprising a metal oxide in a wavelength range of 8200 nm or more and 9000 nm or less was measured. As described in the text of the specification, the absorbance of the layer comprising a metal oxide at each wavelength was measured by reflection in FTIR, and the absorbance at each wavelength was then transformed into a transmittance at each wavelength to calculate the spectral transmittance of the layer comprising a metal oxide in a wavelength range of 8200 nm or more and 9000 nm or less.

As the FTIR measurement device, Model "NICOLET iS1O" manufactured by Thermo Fisher Scientific was used. As an accessory, "Single Reflection Type Ge ATR Accessory Foundation" manufactured by the same company as above was used. For the measurement conditions, the specimen was pressure-bonded and fixed to a pressure tower with the measurement surface facing the Ge crystal surface, and the measurement was then performed under the following conditions: incidence type: single and 45°; number of scans: 32; resolution: 8; detector: DTGS KBr; mirror speed: 0.6329; aperture: open; and measurement range: 680 $cm^{-1}$ or more and 4000 $cm^{-1}$ or less. The measured absorbance was transformed into a transmittance, and a value in $cm^{-1}$ was transformed into a value in nm to calculate an average value of transmittances in the wavelength range.

1-3. Luminous Reflectance Y Value

A specimen was prepared by bonding a black plate (trade name: COMOGLAS DFA2CG 502K (black) type manufactured by KURARAY CO., LTD., thickness: 2 mm) to the substrate of the optical laminate of each of Examples and Comparative Examples so as to locate the black plate on a side opposite to the layer comprising a metal oxide, with a 25 μm-thick transparent pressure sensitive adhesive layer (trade name: PANACLEAN PD-S1 manufactured by PANAC Co., Ltd.) interposed between the black plate and the substrate. The luminous reflectance Y value was measured with light being incident to the specimen at an incidence angle of 5 degrees from the side of the layer comprising a metal oxide with respect to the substrate.

The luminous reflectance Y value was determined as a value representing a luminous reflectance obtained by measuring a 5° regular reflectance under the conditions of a viewing angle of 2 degrees, a C light source and a wavelength range of 380 nm or more and 780 nm or less by use of a spectral reflectometer (trade name: UV-2450 manufactured by Shimadzu Corporation), and thereafter performing calculation by software (UVPC color measurement Version 3.12 built in apparatus) for conversion into brightness sensed by human eyes.

1-4. Total Light Transmittance and Haze

The JIS K7361-1: 1997-specified total light transmittance and the JIS K7136: 2000-specified haze of the optical laminate of each of Examples and Comparative Examples were measured by use of a haze meter (HM-150 manufactured by Murakami Color Research Laboratory Co., Ltd.). The light incidence surface was on the substrate side.

1-5. Surface Temperature

A simulated liquid crystal display device was prepared by disposing the optical laminate of each of Examples and Comparative Examples on a commercially available liquid crystal device (trade name: Kindle Fire HDX from Amazon.com, Inc.) such that the substrate of the optical laminate faced the display device.

For simulating the interior of an automobile in the summer, the simulated liquid crystal display device was placed in an oven at 80°C, and taken out after 10 minutes. Immediately after the simulated liquid crystal display device was taken out, the temperature was measured from the surface side by an IR camera (trade name: FLIR E4 manufactured by FLIR Systems, Inc.). The distance between the optical film and the IR camera was 30 cm. Table 1 shows the maximum temperatures of the tops of the optical laminates. A maximum temperature of 65°C or lower corresponds to an acceptable level. In consideration of an actual situation of image display, the maximum temperature is more preferably 60°C or lower, further preferably 57°C or lower.

1-6. Visibility (Unevenness)

The simulated liquid crystal display device prepared in 1-5 was placed in an oven at 80°C, and taken out after 10 minutes. Immediately after the simulated liquid crystal display device was taken out, the entire screen of the liquid crystal display device was shown in green color, and whether or not there were portions uneven in lightness and color was visually evaluated. Ten persons having a vision of 0.7 or more served as evaluators. The vision includes a corrected vision. The distance between the evaluator and the liquid crystal display device was 50 cm. A specimen for which eight or more of the persons indicated that there were not portions uneven in lightness and color was rated "A", and a specimen for which seven or less of the persons indicated that there were not portions uneven in lightness and color was rated "C".

2. Preparation of Optical Laminate

[Example 1]

The following coating solution for a hardcoat layer was applied onto a substrate (triacetyl cellulose film, thickness:

60 μm), dried, and irradiated with an ultraviolet ray to form a 5 μm-thick hardcoat layer on the substrate.

Subsequently, the following coating solution 1 for a metal oxide layer was applied onto the hardcoat layer, dried, and irradiated with an ultraviolet ray to form a 350 nm-thick layer comprising ITO particles as metal oxide particles on the hardcoat layer.

Subsequently, the following coating solution for a low refractive index layer was applied onto the layer comprising a metal oxide, dried, and irradiated with an ultraviolet ray to form a 100 nm-thick low refractive index layer on the layer comprising a metal oxide, thereby obtaining an optical laminate of Example 1.

<Coating Solution for Hardcoat Layer>

The following components were mixed to prepare a hardcoat layer forming composition.

- Pentaerythritol triacrylate 46 parts by mass (trade name: KAYARAD PET-30 from Nippon Kayaku Co., Ltd.)
- Photopolymerization initiator 4 parts by mass (trade name: Omnirad 184 from IGM Resins B.V. Company)
- Methyl ethyl ketone 50 parts by mass

<Coating Solution 1 for Metal Oxide Layer>

The following components were mixed to prepare a coating solution 1 for a metal oxide layer.

- Pentaerythritol triacrylate 1 part by mass (trade name: KAYARAD PET-30 from Nippon Kayaku Co., Ltd.)
- ITO particles 8.5 parts by mass (average particle size: 30 nm)
- Photopolymerization initiator 0.4 parts by mass (trade name: Omnirad 184 from IGM Resins B.V. Company)
- Leveling agent 0.03 parts by mass (MEGAFAC F-477 manufactured by DIC Corporation)
- Methyl isobutyl ketone 89 parts by mass

<Coating Solution for Low Refractive Index Layer>

The following components were mixed to prepare a coating solution for a low refractive index layer.

- Pentaerythritol triacrylate 0.4 parts by mass (trade name: KAYARAD PET-30 from Nippon Kayaku Co., Ltd.)
- Fluorine-containing polymer 0.2 parts by mass (solid content) (trade name: JN35 manufactured by JSR Corporation)
- Fluorine-containing monomer 0.7 parts by mass (solid content) (trade name: LINC 3A manufactured by KYOEISHA CHEMICAL Co., LTD.)
- Hollow silica articles 1.7 parts by mass (average particle size: 75 nm and refractive index: 1.212)
- Solid silica particles 0.6 parts by mass (average particle size: 15 nm)
- Leveling agent 0.06 parts by mass (trade name: X-22-164E from Shin-Etsu Silicone)
- Photopolymerization initiator 0.09 parts by mass (trade name: Omnirad 127 from IGM Resins B.V. Company)
- Solvent 97 parts by mass (mixed solvent of methyl isobutyl ketone and propylene glycol monomethyl ether acetate at a mass ratio of 70 : 30, prepared on the basis of a thickness with a solid content of 2 mass%)

[Example 2]

Except that the thickness of the layer comprising a metal oxide was changed to 700 nm, the same procedure as in Example 1 was carried out to obtain an optical laminate of Example 2.

[Example 3]

Except that the thickness of the layer comprising a metal oxide was changed to 200 nm, the same procedure as in Example 1 was carried out to obtain an optical laminate of Example 3.

[Example 4]

Except that the substrate (triacetyl cellulose film, thickness: 60 μm) was changed to a 100 μm-thick biaxially stretched polyethylene terephthalate film, the same procedure as in Example 1 was carried out to obtain an optical laminate of Example 4.

17

[Example 5]

Except that for the layer comprising a metal oxide, the coating solution 1 for a metal oxide layer was changed to the following coating solution 2 for a metal oxide layer, and the thickness was changed to 900 nm, the same procedure as in Example 1 was carried out to obtain an optical laminate of Example 5.

<Coating Solution 2 for Metal Oxide Layer>

- Pentaerythritol triacrylate 1 part by mass (trade name: KAYARAD PET-30 from Nippon Kayaku Co., Ltd.)
- Al doped ZnO particles 9.6 parts by mass
- Photopolymerization initiator 0.4 parts by mass (trade name: Omnirad 184 from IGM Resins B.V. Company)
- Leveling agent 0.03 parts by mass (MEGAFAC F-477 manufactured by DIC Corporation)
- Methyl isobutyl ketone 89 marts by mass

[Example 6]

The coating solution 1 for a metal oxide layer was changed to the following coating solution 3 for a metal oxide layer, and the thickness of the layer comprising a metal oxide was changed to 900 nm. Further, a step of performing heating at 100°C for 60 minutes was added after the coating solution for a metal oxide layer was applied, dried, and irradiated with an ultraviolet ray. Except for the aforementioned changes and additions, the same procedure as in Example 1 was carried out to obtain an optical laminate of Example 6.

[Example 7]

The coating solution for a hardcoat layer was applied onto a substrate (cycloolefin polymer film, thickness: 47 μm), dried, and irradiated with an ultraviolet ray to form a 5 μm-thick hardcoat layer on the substrate.
Subsequently, the following coating solution 3 for a metal oxide layer was applied onto the hardcoat layer, dried, and irradiated with an ultraviolet ray to form a 900 nm-thick layer comprising ITO particles as metal oxide particles on the hardcoat layer, and heating was then performed at 150°C for 60 minutes.
Subsequently, the coating solution for a low refractive index layer was applied onto the layer comprising a metal oxide, dried, and irradiated with an ultraviolet ray to form a 100 nm-thick low refractive index layer on the layer comprising a metal oxide, thereby obtaining an optical laminate of Example 7.

<Coating Solution 3 for Metal Oxide Layer>

The following components were mixed to prepare a coating solution 3 for a metal oxide layer.

- Pentaerythritol triacrylate 0.5 parts by mass (trade name: KAYARAD PET-30 from Nippon Kayaku Co., Ltd.)
- ITO particles 9 parts by mass (average particle size: 30 nm)
- Photopolymerization initiator 0.4 parts by mass (trade name: Omnirad 184 from IGM Resins B.V. Company)
- Leveling agent 0.03 parts by mass (MEGAFAC F-477 manufactured by DIC Corporation)
- Methyl isobutyl ketone 89 marts by mass

[Example 8]

On a substrate (100 μm-thick biaxially stretched polyethylene terephthalate film), a hardcoat layer was formed in the same manner as in Example 1.
Subsequently, a 130 nm-thick metal oxide film was formed on the hardcoat layer by performing sputtering using an ITO target while introducing argon mixed with oxygen gas. The ITO target comprises indium and tin at a mass ratio of 90 : 10. The metal oxide film is an amorphous film of ITO.
Subsequently, a surface of the metal oxide film was subjected to corona discharge treatment, and the same low refractive index layer as in Example 1 was then formed on the metal oxide film to obtain an optical laminate of Example 8.

[Comparative Example 1]

A 140 nm-thick metal oxide film was formed on a 0.7 mm-thick glass substrate by performing sputtering using an ITO target while introducing argon mixed with oxygen gas. The ITO target comprises indium and tin at a mass ratio of 90 : 10. Subsequently, the metal oxide film was heated at 200°C for 30 minutes to be subjected to annealing treatment, thereby obtaining an optical laminate of Comparative Example 1 in which a 140 nm-thick crystal film of ITO is present on a glass substrate.

[Comparative Example 2]

The following coating solution for a heat dissipation layer was applied onto a substrate (triacetyl cellulose film, thickness: 60 μm), dried, and irradiated with an ultraviolet ray to form a 1 μm-thick heat dissipation layer, thereby obtaining an optical laminate of Comparative Example 2.

<Coating Solution for Heat Dissipation Layer>

The following components were mixed to prepare a coating solution for a heat dissipation layer.

- Pentaerythritol triacrylate 3.2 parts by mass (trade name: KAYARAD PET-30 from Nippon Kayaku Co., Ltd.)
- Boron nitride particles 6.4 parts by mass (average particle size: 700 nm)
- Photopolymerization initiator 0.4 parts by mass (trade name: Omnirad 184 from IGM Resins B.V. Company)
- Methyl ethyl ketone 90 parts by mass

[Table 1]

| | | Example | | | | | | | | Comparative Example | |
|---|---|---|---|---|---|---|---|---|---|---|---|
| | | 1 | 2 | 3 | 4 | 5 | 6 | 7 | 8 | 1 | 2 |
| Emissivity α | | 0.70 | 0.60 | 0.73 | 0.67 | 0.72 | 0.43 | 0.38 | 0.30 | 0.22 | 0.88 |
| Spectral transmittance (%) | | 70 | 60 | 72 | 65 | 70 | 50 | 34 | 78 | 91 | 90 |
| Y value (%) | | 0.3 | 0.4 | 0.3 | 0.5 | 0.8 | 0.4 | 0.4 | 0.4 | 5.7 | - |
| Total light transmittance (%) | | 94 | 93 | 95 | 94 | 91 | 93 | 92 | 94 | 86 | 89 |
| Haze (%) | | 0.6 | 0.8 | 0.6 | 0.8 | 1.0 | 0.9 | 0.9 | 0.3 | 0.2 | 18.9 |
| Evaluation | Emissivity α | A | AA | A | A | A | AA | AA | A | B | C |
| | Surface temperature (°C) | 60 | 56 | 63 | 59 | 61 | 51 | 44 | 45 | 37 | 70 |
| | Visibility | A | A | A | A | A | A | A | A | C | C |

From the results in Table 1, it can be confirmed that the optical laminate of the present disclosure is capable of suppressing deterioration of visibility in a high-temperature environment.

A mandrel test was conducted on the optical laminates of Examples 1 to 8 in accordance with JIS K5600-5-1: 1999. Specifically, a test piece of 100 mm × 25 mm was cut out from the optical laminate of each of Examples 1 to 8, and wound around a mandrel bar such that the short sides of the test piece were parallel to the mandrel bar. The test piece was wound around the mandrel bar in a state of being bent outward. As the mandrel bar, mandrel bars of φ10 mm and φ6 mm were used.

The results of the mandrel tests described above showed that at φ10 mm, the optical laminates of Examples 1 to 8 had no cracks in the layer comprising a metal oxide and the low refractive index layer. Even at φ6 mm, the optical laminates of Examples 1 to 3 and 5 to 7 had no cracks in the layer comprising a metal oxide and the low refractive index layer. From these results, it can be said that the optical laminates of Examples 1 to 8 have good flex resistance, and is easily applied to a foldable image display device and a rollable image display device. It can also be seen that among the optical laminates of Examples, those of Examples 1 to 3 and 5 to 7 have extremely good flex resistance.

Reference Signs List

10: Plastic film
20: Functional layer α
21: Hardcoat layer
30: Layer comprising a metal oxide
40: Functional layer β
41: Low refractive index layer
100: Optical laminate

**Claims**

1. An optical laminate, comprising a layer comprising a metal oxide on a plastic film,
   wherein an emissivity of the optical laminate for light with a wavelength range of 2000 nm or more and 22000 nm or less is 0.27 or more and 0.75 or less as measured from a side of the layer comprising a metal oxide with respect to the plastic film.

2. The optical laminate according to claim 1, wherein an average of spectral transmittance of the layer comprising a metal oxide in a wavelength range of 8200 nm or more and 9000 nm or less is 80% or less.

3. The optical laminate according to claim 1 or 2, wherein the layer comprising a metal oxide comprises metal oxide particles as the metal oxide, and a binder resin.

4. The optical laminate according to claim 3, wherein the metal oxide particles comprise indium tin oxide particles.

5. The optical laminate according to any one of claims 1 to 4, comprising at least one functional layer α between the plastic film and the layer comprising a metal oxide.

6. The optical laminate according to claim 5, comprising a hardcoat layer as the functional layer α.

7. The optical laminate according to any one of claims 1 to 6, comprising at least one functional layer β on the layer comprising a metal oxide, side opposite to the plastic film.

8. The optical laminate according to claim 7, wherein a total thickness of the at least one functional layer β is 1000 nm or less.

9. The optical laminate according to claim 7 or 8, comprising a low refractive index layer as the functional layer β.

10. The optical laminate according to any one of claims 1 to 9, wherein a luminous reflectance Y value of the optical laminate is 2.0% or less as measured from the side of the layer comprising a metal oxide with respect to the plastic film.

11. A polarizing plate comprising: a polarizer; a first transparent protection plate disposed on one side of the polarizer; and a second transparent protection plate disposed on the other side of the polarizer, wherein at least one selected from the group consisting of the first transparent protection plate and the second transparent protection plate is the optical laminate according to any one of claims 1 to 10.

12. A surface plate for an image display device, comprising the optical laminate according to any one of claims 1 to 10 bonded onto a resin plate or a glass plate.

13. An image display device comprising the optical laminate according to any one of claims 1 to 10 on a light emitting surface side of a display element.

[Fig. 1]

## INTERNATIONAL SEARCH REPORT

International application No.

PCT/JP2021/010718

### A. CLASSIFICATION OF SUBJECT MATTER

G02B 1/111(2015.01)i; B32B 7/023(2019.01)i; B32B 9/00(2006.01)i; B32B
9/04(2006.01)i; B32B 27/06(2006.01)i; B32B 27/18(2006.01)i; G02B
1/14(2015.01)i; G02B 5/22(2006.01)i; G02B 5/26(2006.01)i; G02B
5/30(2006.01)i; G02F 1/1335(2006.01)i; G09F 9/00(2006.01)i; H01L
27/32(2006.01)i; H01L 51/50(2006.01)i; H05B 33/02(2006.01)i
FI:      G02B1/111; B32B7/023; B32B9/00 A; B32B9/04; B32B27/06; B32B27/18
         Z; G02B1/14; G02B5/22; G02B5/26; G02B5/30; G02F1/1335 510;
         G09F9/00 304Z; G09F9/00 313; H01L27/32; H05B33/02; H05B33/14 A

According to International Patent Classification (IPC) or to both national classification and IPC

### B. FIELDS SEARCHED

Minimum documentation searched (classification system followed by classification symbols)
G02B1/10-1/18; B32B7/023; B32B9/00; B32B9/04; B32B27/06; B32B27/18;
G02B5/22; G02B5/26; G02B5/30; G02F1/1335-1/13363; G09F9/00; H01L27/32;
H01L51/50; H05B33/02

Documentation searched other than minimum documentation to the extent that such documents are included in the fields searched
Published examined utility model applications of Japan     1922-1996
Published unexamined utility model applications of Japan   1971-2021
Registered utility model specifications of Japan           1996-2021
Published registered utility model applications of Japan   1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2018-171908 A (NITTO DENKO CORP.) 08 November 2018 (2018-11-08) paragraphs [0014]-[0238], fig. 1-4 | 1-2, 5-10<br>3-13 |
| Y | JP 8-281860 A (SUMITOMO OSAKA CEMENT CO., LTD.) 29 October 1996 (1996-10-29) paragraphs [0008]-[0009], [0011]-[0014], [0026]-[0027], fig. 1-2 | 3-13 |
| Y | JP 2000-117906 A (TOMOEGAWA CO., LTD.) 25 April 2000 (2000-04-25) paragraphs [0009]-[0025] | 3-13 |

☐ Further documents are listed in the continuation of Box C.     ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 31 May 2021 (31.05.2021) | 08 June 2021 (08.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2021/010718

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2010/109723 A1 (SHARP CORP.) 30 September 2010 (2010-09-30) paragraphs [0011]-[0050], [0053]-[0109], fig. 1-8 | 11-13 |

Form PCT/ISA/210 (continuation of second sheet) (January 2015)

International application No.

PCT/JP2021/010718

| Patent Documents referred in the Report | Publication Date | Patent Family | Publication Date |
|---|---|---|---|
| JP 2018-171908 A | 08 Nov. 2018 | US 2020/0379153 A1 paragraphs [0017]-[0265], fig. 1-4 EP 3605165 A1 CN 110462463 A TW 201843042 A KR 10-2019-0131495 A | |
| JP 8-281860 A | 29 Oct. 1996 | (Family: none) | |
| JP 2000-117906 A | 25 Apr. 2000 | US 6528156 B1 column 3, line 4 to column 7, line 61 EP 1040913 B1 EP 1040913 A1 WO 00/23274 A1 | |
| WO 2010/109723 A1 | 30 Sep. 2010 | US 2011/0310470 A1 paragraphs [0013]-[0051], [0061]-[0118], fig. 1-8 CN 102341837 A CN 102341837 B | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019167897 A